**Europäisches Patentamt**

**European Patent Office**

**Office européen des brevets**

(19)

(11) Veröffentlichungsnummer: **0 152 578**
**B1**

(12) # EUROPÄISCHE PATENTSCHRIFT

(45) Veröffentlichungstag der Patentschrift:
27.04.88

(51) Int. Cl.⁴: **H 03 K 17/292**

(21) Anmeldenummer: **84115061.8**

(22) Anmeldetag: **10.12.84**

(54) **Nachlaufanordnung.**

(30) Priorität: **14.02.84 DE 3405196**

(43) Veröffentlichungstag der Anmeldung:
**28.08.85 Patentblatt 85/35**

(45) Bekanntmachung des Hinweises auf die Patenterteilung:
**27.04.88 Patentblatt 88/17**

(84) Benannte Vertragsstaaten:
**AT BE CH DE FR GB IT LI NL SE**

(56) Entgegenhaltungen:
**DE-A-2 052 276**
**DE-A-2 312 354**
**DE-A-2 847 061**

(73) Patentinhaber: **Siemens Aktiengesellschaft Berlin und München, Wittelsbacherplatz 2, D-8000 München 2 (DE)**

(72) Erfinder: **Fröbel, Eckhard, Karl- Alexander- Strasse 2, D-8400 Regensburg (DE)**

## Beschreibung

Die Erfindung betrifft eine Nachlaufanordnung mit einem Nachlaufschalter, der einen Handschalter und einen durch ein Steuerglied mit Zeitglied angesteuerten elektronischen Schalter aufweist, wobei beim Schließen des Handschalters zwei in getrennten Zweigen eines Stromkreises angeordnete Verbraucher gleichzeitig einschalten und beim Öffnen des Handschalters der erste Verbraucher sofort und der zweite Verbraucher durch Steuerglied und elektronischen Schalter zeitlich verzögert ausschaltet.

Derartige Nachlaufanordnungen mit einem Nachlaufschalter sind bekannt. Dabei sind in einem Stromkreis zwei Verbraucher, z. B. eine Lampe und ein Motor zum Antrieb eines Ventilators, parallelgeschaltet. Im Zweig der Lampe ist ein Handschalter und im Zweig des Motors ein von einem Steuerglied angesteuerter elektronischer Schalter angeordnet. Dieser elektronische Schalter kann ein Triac sein, mit dessen Gate der Steuerausgang des Steuergliedes in Verbindung steht. Mit einer ersten Anschlußklemme des Steuergliedes, das eine Verzögerungsschaltung, beispielsweise ein RC-Glied enthält, steht ein Abgriff im Lampenzweig zwischen Handschalter und Lampe in Verbindung. Die zweite Anschlußklemme des Steuergliedes ist mit dem Nulleiter verbunden. Für derartige bekannte Nachlaufanordnungen sind am Nachlaufschalter in einer Unterputzdose insgesamt vier Anschlußkabel anzubringen, die Verbindungskabel zur Lampe und zum Motor, Phase und Nulleiter.

Wenn ein Handschalter eines solchen Nachlaufschalters geschlossen wird, schaltet die Lampe ein. Gleichzeitig liegt ein Potential an der ersten Anschlußklemme des Steuergliedes, das sofort an seinem Steuerausgang ein Signal abgibt und das Triac durchschaltet. Dadurch läuft der Motor sofort an.

Wenn der Handschalter geöffnet wird, schaltet die Lampe sofort aus. Die erste Anschlußklemme des Steuergliedes liegt dann auf Nullpotential. Durch ein Zeitglied verzögert liegt daraufhin auch am Steuerausgang das Nullsignal an und das Triac im Motorzweig sperrt. Die Zeitspanne zwischen Ausschalten der Lampe und Ausschalten des Motors bestimmt das Zeitglied im Steuerglied.

Das Triac derartiger bekannter Nachlaufschalter wird während der gesamten Laufzeit des Motors angesteuert. Die Belastung und damit die Störanfälligkeit des Triacs wie auch des Steuergliedes sind dadurch groß. Wegen der großen Belastung benötigt man für das Triac eine Kühlfahne zum Abführen von Wärme, die während der langen Betriebszeit entsteht. Diese Kühlfahne benötigt zusätzlichen Platz im an sich kleinen Schaltergehäuse.

Wenn das sehr beanspruchte Triac defekt sein sollte, kann bei einem derartigen Nachlaufschalter der Motor nicht mehr geschaltet werden. Es kann nur noch die Lampe in Betrieb genommen werden.

Der Erfindung liegt die Aufgabe zugrunde, eine Nachlaufanordnung zu entwickeln, deren Bauteile raumsparend unterzubringen sind, insbesondere bei einem Nachlaufschalter, der in eine reguläre Unterputzdose eingesetzt werden kann.

Diese Aufgabe wird erfindungsgemäß dadurch gelöst,
- daß der Handschalter einen ersten mechanischen Schalter im Zweig des ersten Verbrauchers und mit diesem mechanisch gekoppelt einen zweiten, gleichsinnig schaltenden mechanischen Schalter im Zweig des zweiten Verbrauchers aufweist,
- daß der elektronische Schalter den zweiten mechanischen Schalter überbrückend angeordnet ist, und
- daß das Steuerglied mit seinen Anschlüssen parallel zum ersten mechanischen Schalter angeschlossen ist und der Steuerausgang des Steuergliedes mit dem Schalteingang des elektronischen Schalters in Verbindung steht, wobei der Steuerausgang des Steuergliedes bei einer Spannungsabsenkung am lastseitigen Anschluß auf EIN schaltet und dann nach einer festen durch ein Zeitglied bestimmten Zeitspanne wieder auf AUS schaltet.

Bei der Nachlaufanordnung nach der Erfindung liegen bei geschlossenem Handschalter des Nachlaufschalters beide Verbraucher, z. B. eine Lampe und ein Motor für einen Ventilator, über mechanische Schalter am Netz und an beiden Anschlüssen des parallel zum ersten mechanischen Schalter angeordneten Steuergliedes liegt das gleiche Potential an. Das Steuerglied registriert Spannungsabsenkungen an seinem lastseitigen Anschluß, der mit einem Abgriff zwischen erstem mechanischen Schalter und Lampe verbunden ist. Das Steuerglied wird also beim Öffnen des Handschalters aktiviert und gibt dann sofort an seinem Steuerausgang ein Signal ab. Dieses Signal wird dem Schalteingang des elektronischen Schalters beispielsweise eines Triacs zugeführt, das dann den zweiten mechanischen Schalter leitend überbrückt. Dieses Steuersignal wird für eine durch ein RC-Glied im Steuerglied bestimmte Zeitspanne aufrechterhalten, so, daß das Triac, das beim Öffnen des Handschalters durchsteuerte, nach dieser vorgewählten Zeitspanne wieder sperrt. Sonach läuft der Motor nach dem Ausschalten der Lampe noch für eine durch das Zeitglied bestimmte Zeitspanne weiter.

Mit diesem Nachlaufschalter wird der Vorteil erzielt, daß der elektronishe Schalter, das Triac, nur während der Nachlaufzeit des Motors eingeschaltet ist. Der Motor wird bei geschlossenem Handschalter über den zweiten mechanischen Schalter versorgt und erst nach Öffnen des Handschalters für die Nachlaufzeit über das parallel geschaltete Triac versorgt. Der Nachlaufschalter wird daher geschont, so daß er länger betriebsbereit ist als die auf dem Markt befindlichen Schalter. Die elektronischen Bauteile werden also weniger belastet. Wesentlich ist weiter, daß selbst bei einem Defekt an diesen Bauteilen der Motor betriebsbereit bleibt.

Infolge der geringeren Betriebszeiten des Triacs benötigt man keine Kühlfahne, weshalb sich der Nachlaufschalter kleiner dimensionieren läßt. Die geringeren Einschaltzeiten des Triacs vermindern auch mögliche Defekte.

Trotzdem wird mit dem Nachlaufschalter nach der Erfindung weiter der Vorteil erzielt, daß der Motor auch bei defektem Triac betriebsbereit ist. Er würde dann nur gleichzeitig mit der Lampe ausschalten, da nur während der Nachlaufzeit der Strom zum Motor über das Triac fließt.

Mit der Anordnung des Steuergliedes nach der Erfindung parallel zum ersten mechanischen Schalter werden die Vorteile erzielt, daß der Nachlaufschalter nur drei Anschlüsse, die Verbindungskabel zur Lampe und zum Motor und den Phasenanschluß, benötigt und auch daß bei geschlossenem Handschalter am Steuerglied keine Spannung anliegt. Dadurch werden unerwünschte Fehlschaltungen des Steuergliedes verhindert.

Nach einer Weiterbildung am Nachlaufschalter ist dem Eingang des Steuergliedes eine Diode in Durchlaßrichtung in Reihe mit einem hochohmigen Widerstand vorgeschaltet. Dadurch wird der Potentialverlauf den Erfordernissen des Steuergliedes angepaßt.

Die Erfindung soll anhand eines in der Zeichnung grob schematisch wiedergegebenen Ausführungsbeispiels näher erläutert werden:

Fig. 1 zeigt das Schaltbild einer erfindungsgemäßen Nachlaufanordnung.

Fig. 2 veranschaulicht den Stromfluß im Zweig des Handschalters des Nachlaufschalters und abhängig davon den Stromverlauf im Zweig des Triacs.

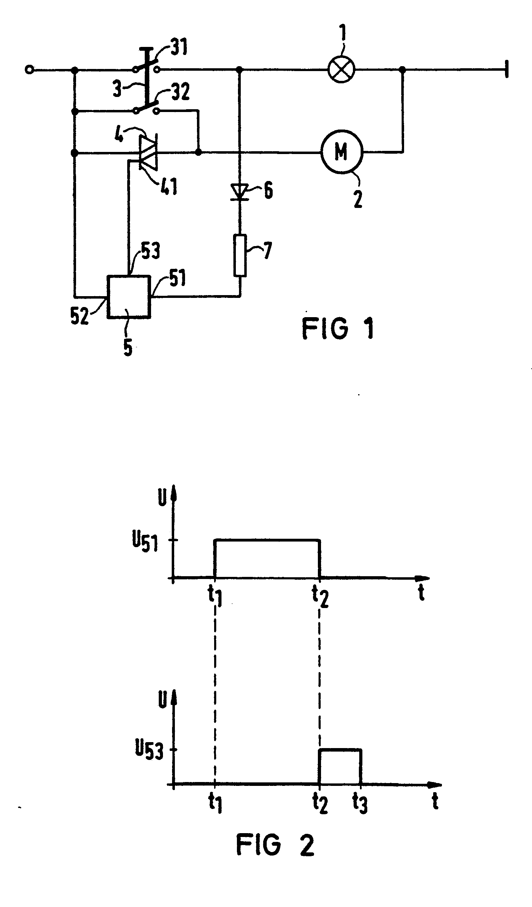

Die Nachlaufanordnung arbeitet mit einem Nachlaufschalter nach Fig. 1. Dieser schaltet eine Lampe 1 und einen Motor 2 eines Ventilators gleichzeitig ein. Nach dem Ausschalten der Lampe 1 läuft der Motor 2 noch für eine feste Zeitspanne weiter. Die Lampe 1 und der Motor 2 sind in getrennten Zweigen eines Stromkreises angeordnet. Ein Handschalter 3 weist einen ersten mechanischen Schalter 31 im Zweig der Lampe 1 und einen zweiten mechanischen Schalter 32 im Zweig des Motors 2 auf. Die beiden mechanischen Schalter 31 und 32 sind durch eine starre nicht leitende Verbindung aneinander gekoppelt und werden mit nur einem Handbetätigungsglied immer gleichzeitig geöffnet oder geschlossen.

Im Zweig des Motors 2 ist den zweiten mechanischen Schalter 32 überbrückend ein Triac 4 angeordnet, mit dessen Gate 41 ein Steuerausgang 53 eines Steuergliedes 5 in Verbindung steht.

Das Steuerglied 5 ist parallel zum ersten mechanischen Schalter 31 geschaltet, der sich im Zweig der Lampe befindet. Bei einer Spannungsabsenkung am lastseitigen Anschluß 51 des Steuergliedes 5, wie sie beim Öffnen des Handschalters 3 erzeugt wird, liegt eine Spannung am Steuerausgang 53 des Steuergliedes 5. Dadurch wird das Triac 4 durchgesteuert. Sonach fließt auch nach Öffnen des Handschalters 3 ein Strom über das Triac 4 und speist den Motor 2.

Das Steuerglied 5 enthält ein Zeitglied, beispielsweise ein RC-Glied, das vom Zeitpunkt einer Spannungsabsenkung am lastseitigen Anschluß 51 an nach einer festen vorgewählten Zeitspanne die Spannung am Steuerausgang 53 wieder auf Null setzt. Folglich sperrt das Triac 4 und bei weiterhin geöffnetem Handschalter 3 schaltet der Motor 2 aus.

Zum Schutz des Steuergliedes 5 sind in der Zuleitung des lastseitigen Anschlusses 51 des Steuergliedes 5 eine Diode 6 und ein hochohmiger Widerstand 7 in Serie geschaltet.

Zum Verdeutlichen der Funktionsweise des Nachlaufschalters nach der Erfindung zeigt Fig. 2 für den Zeitraum einer Schaltperiode schematisiert den Verlauf der Spannung $U_{51}$ am lastseitigen Anschluß 51 sowie den Verlauf der Spannung $U_{53}$ am Steuerausgang 53 des Steuergliedes 5.

Wenn der Handschalter 3 zum Zeitpunkt t1 geschlossen wird, liegt die Netzspannung sowohl an der Lampe 1 als auch am Motor 2 an. Gleichzeitig liegt eine Spannung $U_{51}$ am Anschluß 51 des Steuergliedes 5 an. Am zweiten Anschluß 52 des Steuergliedes 5 liegt aber die gleiche Spannung an, so daß der Steuerausgang 53 auf AUS bleibt und das Triac 4 nicht angesteuert wird. Das Triac 4 wird also jetzt noch nicht belastet und ein möglicher Defekt des Triacs wirkt sich noch nicht auf die Funktion der Lampe 1 und des Motors 2 aus.

Wenn zum Zeitpunkt t2 der Handschalter 3 wieder geöffnet wird, schaltet die Lampe 1 im ersten Zweig des Stromkreises sofort aus und die Spannung U51 am lastseitigen Anschluß 51 des Steuergliedes 5 fällt auf Null. Diese Spannungsabsenkung am Anschluß 51 triggert das Steuerglied, dessen Steuerausgang 53 auf EIN schaltet. Sonach wird das Triac 4 durchgeschaltet und der mechanische Schalter 32 im Zweig des Motors 2 überbrückt. Bei ausgeschalteter Lampe 1 läuft also der Motor 2 weiter.

Nach einer festen Zeitspanne, die vom Zeitpunkt t2 der Spannungsabsenkung am Anschluß 51 an durch ein RC-Glied im Steuerglied 5 bestimmt wird, schaltet das Steuerglied 5 zum Zeitpunkt t3 den Steuerausgang 53 wieder auf AUS. Sonach sperrt das Triac 4 und der Motor 2 schaltet bei weiterhin geöffnetem Handschalter 3 verzögert aus.

**Patentansprüche**

1. Nachlaufanordnung mit einem Nachlaufschalter, der einen Handschalter (3) und

3

einen durch ein Steuerglied (5) mit Zeitglied angesteuerten elektronischen Schalter (4) aufweist, wobei beim Schließen des Handschalters (3) zwei in getrennten Zweigen eines Stromkreises angeordnete Verbraucher (1, 2) gleichzeitig einschalten und beim Öffnen des Handschalters (3) der erste Verbraucher (1) sofort und der zweite Verbraucher (2) durch Steuerglied (5) und elektronischen Schalter (4) zeitlich verzögert ausschaltet, dadurch gekennzeichnet,

- daß der Handschalter (3) einen ersten mechanischen Schalter (31) im Zweig des ersten Verbrauchers (1) und mit diesem mechanisch gekoppelt einen zweiten, gleichsinnig schaltenden mechanischen Schalter (32) im Zweig des zweiten Verbrauchers (2) aufweist,

- daß der elektronische Schalter (4) den zweiten mechanischen Schalter (32) überbrückend angeordnet ist, und

- daß das Steuerglied (5) mit seinen Anschlüssen (51, 52) parallel zum ersten mechanischen Schalter (32) angeschlossen ist und der Steuerausgang (53) des Steuergliedes (5) mit dem Schalteingang (41) des elektronischen Schalters (4) in Verbindung steht, wobei der Steuerausgang (53) des Steuergliedes (5) bei einer Spannungsabsenkung am lastseitigen Anschluß (51) auf EIN schaltet und dann nach einer festen durch ein Zeitglied bestimmten Zeitspanne wieder auf AUS schaltet.

2. Nachlaufanordnung nach Anspruch 1, dadurch gekennzeichnet, daß ein Triac als elektronischer Schalter (4) verwendet wird und daß der Steuerausgang (53) des Steuergliedes (5) mit dem Gate des Triacs in Verbindung steht.

3. Nachlaufanordnung nach Anspruch 2, dadurch gekennzeichnet, daß dem lastseitigen Anschluß (51) des Steuergliedes (5) eine Diode (6) in Reihe mit einem hochohmigen Widerstand (7) vorgeschaltet ist.

4. Nachlaufanordnung nach den Ansprüchen 1 bis 3, dadurch gekennzeichnet, daß der erste Verbraucher (1) eine Lampe ist.

5. Nachlaufanordnung nach den Ansprüchen 1 bis 4, dadurch gekennzeichnet, daß der zweite Verbraucher (2) ein Motor eines Ventilators ist.

**Claims**

1. A follow-up switching arrangement comprising a follow-up stage which includes a manual switch (3) and an electronic switch (4) driven by a control component (5) with timer, where, when the manual switch (3) is closed, two loads (1, 2), arranged in separate arms of a circuit, are simultaneously switched on and where, when the manual switch (3) is opened, the first load (1) is switched off immediately and the second load (2) is switched off with a time delay by means of the control component (5) and the electronic switch (4), characterised in that

- the manual switch (3) comprises a first mechanical switch (31) in the arm of the first load (1), and, mechanically coupled thereto, a second mechanical switch (32) which switches in the same direction as the first switch, in the arm of the second load (2),

- the electronic switch (4) is arranged so as to bridge the second mechanical switch (32) and

- the control component (5) is connected with its terminals (51, 52) parallel to the first mechanical switch (32), and the control output (53) of the control component is connected to the switching input (41) of the electronic switch (4), where, in the event of a voltage reduction at the load-end terminal (51), the control output (53) of the control component (5) switches to ON and then, following a fixed interval of time determined by a timer, switches back to OFF.

2. A follow-up switching arrangement as claimed in Claim 1, characterised in that a triac is used as the electronic switch (4) and that the control output (53) of the control component (5) is connected to the gate of the triac.

3. A follow-up switching arrangement as claimed in Claim 2, characterised in that the load-end terminal (51) of the control component (5) is preceded by a diode (6) in series with a high value resistor (7).

4. A follow-up switching arrangement as claimed in Claims 1 to 3, characterised in that the first load (1) is a lamp.

5. A follow-up switching arrangement as claimed in Claims 1 to 4, characterised in that the second load (2) is a motor of a fan.

**Revendications**

1. Dispositif de débranchement retardé comportant un interrupteur de débranchement retardé, qui comporte un interrupteur manuel (3) et un interrupteur électronique (4) commandé par un circuit de commande (5) comportant un circuit de temporisation et dans lequel, lors de la fermeture de l'interrupteur manuel (3), deux appareils d'utilisation (1, 2) montés dans des branches séparées d'un circuit, sont branchés simultanément et, lors de l'ouverture de l'interrupteur manuel (3), le premier appareil d'utilisation (1) est débranché immédiatement et le second appareil d'utilisation (2) est débranché d'une manière retardée par le circuit de commande (5) et par l'interrupteur électronique (4), caractérisé en ce

- que l'interrupteur manuel (3) comporte un premier interrupteur mécanique (31) situé dans la branche du premier appareil d'utilisation (1), et un second interrupteur mécanique (32) qui est accouplé mécaniquement au premier interrupteur, réalise une commutation dans le même sens et est disposé dans la branche du second appareil d'utilisation (2),

- que l'interrupteur électronique (4) est branché en parallèle avec le second interrupteur mécanique (31); et

- que le circuit de commande (5) est raccordé, par ses bornes (51, 52), en parallèle avec le premier interrupteur mécanique (32) et que la sortie de commande (53) du circuit de commande (5) est reliée à l'entrée de commutation (40) de l'interrupteur électronique (4), auquel cas la sortie de commande (53) du circuit de commande (5) est branchée dans le cas d'une diminution de la tension présente sur la borne (51) située du côté charge et est à nouveau débranchée au bout d'un intervalle de temps fixe déterminé par un circuit de temporisation.

2. Dispositif de débranchement retardé suivant la revendication 1, caractérisé par le fait qu'un triac est utilisé comme interrupteur électronique (4) et que la sortie de commande (53) du circuit de commande (5) est raccordée à la grille du triac.

3. Dispositif de débranchement retardé suivant la revendication 2, caractérisé par le fait qu'une diode (6) branchée en série avec une résistance de forte valeur ohmique (7) est branchée en amont de la borne (51), située du côté charge, du circuit de commande (5).

4. Dispositif de débranchement retardé suivant les revendications 1 à 3, caractérisé par le fait que le premier appareil d'utilisation (1) est une lampe.

5. Dispositif de débranchement retardé suivant les revendications 1 à 4, caractérisé par le fait que le second appareil d'utilisation (2) est le moteur d'un ventilateur.

FIG 1

FIG 2